# EUROPÄISCHE PATENTSCHRIFT

(11) **EP 3 482 459 B1**
(45) Veröffentlichungstag und Bekanntmachung des Hinweises auf die Patenterteilung: **26.01.2022**
(21) Anmeldenummer: 17736940.2
(22) Anmeldetag: 07.07.2017
(51) Int. Cl.: H05K 3/34, H01P 5/08, H01R 9/05, H01R 24/50, H01R 12/53, H05K 1/11

(54) **KABELMONTAGE FÜR KOAXIALKABEL AUF DICKEN LEITERPLATTEN**
COAXIAL CABLE INSTALLATION ON THICK PRINTED CIRCUIT BOARD
INSTALLATION DE CÂBLE COAXIAL SUR PLAQUETTE DE CIRCUITS IMPRIMÉS D'ÉPAISSEUR

(30) Priorität: 08.07.2016 DE 102016212492
(43) Veröffentlichungstag der Anmeldung: 15.05.2019
(73) Patentinhaber: Hirschmann Car Communication GmbH, 72654 Neckartenzlingen (DE)
(72) Erfinder: HEILEMANN, Ingo, 31303 Burgdorf (DE); GELMAN, Alexander, 70736 Fellbach (DE); STAHL, Rainer, 70193 Stuttgart (DE)
(74) Vertreter: Patentanwaltskanzlei WILHELM & BECK
(86) Internationale Anmeldenummer: PCT/EP2017/067069
(87) Internationale Veröffentlichungsnummer: WO 2018/007580

(56) Entgegenhaltungen:
- EP-A2- 1 168 481
- DE-A1-102004 060 416
- US-A- 5 532 659
- US-A- 6 007 347
- US-A1- 2001 042 907
- US-A1- 2005 020 115

## Beschreibung

Die Erfindung betrifft ein Verfahren zum Verbinden einer Leiterplatte mit einem Koaxialkabel, wobei das Koaxialkabel einen Innenleiter aufweist, der von einem Dielektrikum umgeben ist, das wiederum von einer Abschirmung umgeben ist, wobei das Dielektrikum von einem Außenmantel umgeben ist, wobei der Innenleiter mit einem Kontaktpunkt auf der Leiterplatte zwecks elektrischer Kontaktierung verlötet wird, gemäß den Merkmalen des Oberbegriffes des Patentanspruches 1.

Die Direktmontage von Koaxialkabeln auf Leiterplattenmaterial ist per Handlötvorgang ungenau und im Hochfrequenzbereich undefiniert. Eine zusätzliche platzsparende Zugentlastung ist durch eine durchgehende Fräsung im Leiterplattenmaterial nicht möglich. DE 10 2004 060416 A1, US 5 532 659 A, US 2005/020115 A1, EP 1 168 481 A2, US 6 007 347 A und US 2001/042907 A1 offenbaren ähnliche Verfahren zum Verbinden einer Leiteplatte mit einem Koaxialkabel.

Der Erfindung liegt daher die Aufgabe zugrunde, ein gattungsgemäßes Verfahren zu verbessern.

Diese Aufgabe ist durch die Merkmale des Patentanspruches 1 gelöst. Erfindungsgemäß ist vorgesehen, dass die Leiterplatte mit einer von ihrer Oberfläche ausgehenden Ausnehmung versehen und der Endbereich des Außenmantels des Koaxialkabels zumindest teilweise in die Ausnehmung eingesetzt wird. Dadurch ist die Positionierung des Koaxialkabels, insbesondere dessen Ende, definiert und reproduzierbar gewährleistet. Die Ausnehmung kann innerhalb des Randbereiches der Leiterplatte in die Oberfläche der Leiterplatte eingebracht werden. Damit ist es möglich, das Ende des Koaxialkabels mit seinem Innenleiter (elektrischer Leiter) genau an der Stelle zu positionieren, wo sich ein Kontaktpunkt auf der Leiterplatte für den Innenleiter zwecks seiner elektrischen Kontaktierung befindet. Das bedeutet, dass die Anordnung des Endbereiches des Koaxialkabels an jeder beliebigen Stelle innerhalb der äußeren Ränder der Leiterplatte denkbar ist.

In Weiterbildung der Erfindung ist die Breite der Ausnehmung geringfügig kleiner gewählt als der Außendurchmesser des Außenmantels des Koaxialkabels, wobei dieser zumindest teilweise in die Ausnehmung eingepresst wird. Durch diese geometrische Abstimmung des Koaxialkabels auf die in die Leiterplatte eingebrachte Ausnehmung wird eine Presspassung realisiert, die neben der reproduzierbaren Anordnung des Endbereiches des Koaxialkabels auf der Leiterplatte auch gleichzeitig nach dem Einpressen eine Zugentlastung bewirkt.

In Weiterbildung der Erfindung wird die Ausnehmung von einer Seite der Leiterplatte ausgehend in diese eingebracht. Die Anordnung des Koaxialkabels im Randbereich der Leiterplatte hat den Vorteil, dass dadurch ein Kabelabgang geschaffen wird, sodass die Leiterplatte zum Beispiel innerhalb eines Gehäuses angeordnet und die Grundfläche des Gehäuses vollständig ausfüllt. Damit wird der durch das Gehäuse gebildete Raum für die Leiterplatte optimal genutzt, sodass möglichst viele elektronische Bauteile, die für die Realisierung der Funktion eines entsprechenden elektronischen Gerätes erforderlich sind, innerhalb des Gehäuses untergebracht werden können. Außerdem ist es durch die Anordnung des Kabels im Randbereich der Leiterplatte einfach möglich, dass Koaxialkabel aus einer Seitenwand des Gehäuses herauszuführen. Bei einem solchen elektronischen Gerät handelt es sich beispielsweise um einen Antennenverstärker, insbesondere für die mobile Anwendung in Fahrzeugen.

In Weiterbildung der Erfindung wird die Ausnehmung mittels eines Fräsvorganges in die Leiterplatte eingebracht. Mittels eines einfachen Fräswerkzeuges kann somit die Ausnehmung in einem einfachen Herstellungsschritt in die Leiterplatte eingebracht werden. Die Geometrie des Fräswerkzeuges bestimmt damit die Kontur der Ausnehmung, sodass sich zum Beispiel eckigförmige, halbrunde Ausnehmungen (jeweils im Querschnitt betrachtet) oder andere geometrische Ausnehmungen erzielen lassen. Die Ausnehmung kann mittels eines einzigen Fräsvorganges, bei dem das Fräswerkzeug axial geführt wird und die Ausnehmung bildet, in die Leiterplatte eingebracht werden. Je nach Größe und/oder Tiefe der Ausnehmung ist es auch denkbar, das Fräswerkzeug mehrfach axial und/oder horizontal hin- und herzubewegen.

In Weiterbildung der Erfindung wird die Tiefe der Ausnehmung in der Leiterplatte größer als mindestens die Hälfte des Außendurchmessers des Außenmantels des Koaxialkabels gewählt. Dadurch lässt sich der Außenmantel des Koaxialkabels mindestens mit der Hälfte seines Außendurchmessers in die Leiterplatte einsetzen, sodass ein reproduzierbarer Einsetzvorgang gewährleistet ist. Von besonderem Vorteil ist es in einem solchen Fall, dass die Breite der Ausnehmung geringfügig kleiner gewählt wird als der Außendurchmesser des Außenmantels des Koaxialkabels, um diesen in die Ausnehmung nicht nur tief genug einzusetzen, sondern mittels Presspassung auch festzulegen, wenn der Außenmantel des Koaxialkabels in die vorbereitete Ausnehmung eingedrückt wird.

In Weiterbildung der Erfindung wird die Tiefe der Ausnehmung in der Leiterplatte kleiner oder gleich der Dicke der Leiterplatte gewählt. Dadurch wird zum einen eine ausreichend tiefe Ausnehmung bereitgestellt, die jedoch gleichzeitig die Stabilität der Leiterplatte in keinem Fall beeinträchtigt

Zumindest teilweise neben der Ausnehmung ist ein weiterer Kontaktpunkt vorhanden, mit dem die Abschirmung des Koaxialkabels elektrisch verbunden, insbesondere verlötet wird. Wie schon aus dem Stand der Technik bekannt, weist die Leiterplatte auf ihrer Oberfläche zumindest einen Kontaktpunkt auf, der dazu dient, den Innenleiter des Koaxialkabels dort elektrisch zu verbinden, wobei diese elektrische Verbindung ein Lötvorgang sein kann. Bei Koaxialkabeln, die den elektrischen Innenleiter durch eine Abschirmung umgeben, ist es oftmals erforderlich, dass auch die Abschirmung elektrisch mit dem elektronischen Gerät kontaktiert wird. In diesem Fall ist es nach der Erfindung von besonderem Vorteil, wenn die elektrische Kontaktierung der Abschirmung mit einem weiteren Kontaktpunkt auf der Leiterplatte erfolgt. Daher ist es nicht erforderlich, bei der Montage des Koaxialkabels und seiner elektrischen Kontaktierung die Abschirmung mit anderen Bereichen, wie zum Beispiel einem Gehäuse aus einem elektrisch leitenden Werkstoff, zu kontaktieren. Die Festlegung des Endbereiches des Koaxialkabels und die elektrische Verbindung mit der Leiterplatte erfolgt durch die beiden Kontaktpunkte, von denen einer dem Innenleiter und der andere der Abschirmung zugeordnet ist. Insbesondere erfolgt die elektrische Verbindung beider Kontaktpunkte einmal mit der Abschirmung und einmal mit dem Innenleiter durch einen Lötvorgang.

Die Ausnehmung und ein Teilbereich darum herum werden mit einer Abdeckung versehen. Nachdem der Endbereich des Koaxialkabels auf oder seitlich an der Leiterplatte festgelegt worden ist, ist sowohl die mechanische Anordnung als auch die elektrische Kontaktierung erfolgt, sodass die Funktion des Koaxialkabels im Zusammenspiel mit dem elektronischen Gerät bzw. seiner Leiterplatte fertiggestellt ist. Ergänzend kann jedoch daran gedacht werden, diesen Bereich der mechanischen Festlegung und der elektrischen Kontaktierung des Koaxialkabels an bzw. auf der Leiterplatte zusätzlich mit einer Abdeckung zu versehen, die einen mechanischen Schutz und / oder einen elektrischen Schutz für den Endbereich des Koaxialkabels in oder auf der Leiterplatte bildet. Eine solche Abdeckung kann darüber hinaus entweder nur alleine oder im Zusammenspiel mit dem Einpressen des Endbereiches des Koaxialkabels in die Ausnehmung eine Zugentlastung bilden. Ist die Abdeckung aus einem elektrisch leitfähigen Material, kann sie auf den Außenmantel des Koaxialkabels und/oder dessen Dielektrikum aufgesetzt bzw. aufgepresst werden, um zum Beispiel eine Zugentlastung zu bewirken. Sollen die elektrisch leitfähigen Bereiche (wie Kontaktpunkt, Innenleiter und Abschirmung des Koaxialkabels) vor äußeren Einflüssen geschützt werden, kommt eine Abdeckung aus einem elektrisch nicht leitfähigen Material, zum Beispiel einem Kunststoff, in Betracht.

Es ist vorgesehen, die Abdeckung aus einem flüssigen oder zähflüssigem Material herzustellen und damit den Bereich des Endes des Koaxialkabels sowie die Kontaktpunkte damit zu überziehen. In einem solchen Fall kommt beispielsweise ein Hotmelt-Material zur Anwendung.

In Weiterbildung der Erfindung wird die Ausnehmung in der Leiterplatte in einer Länge eingebracht, die der Summe der Länge des freigelegten Innenleiters, der Länge des freigelegten Dielektrikums, der Länge der freigelegten Abschirmung und der vorgebbaren Länge des Außenmantels des Koaxialkabels entspricht. Durch diese Bemessungsvorschrift wird der gesamte Endbereich des Koaxialkabels mit seinem freigelegten Innenleiter (zwecks Kontaktierung mit dem Kontaktpunkt) sowie der freigelegten Abschirmung (ebenfalls zwecks Kontaktierung mit dem Kontaktpunkt auf der Leiterplatte) und dem Außenmantel, der in die Ausnehmung eingesetzt, vorzugsweise eingepresst wird, bemessen. Die Teilbereiche, insbesondere die freigelegten Teilbereiche richten sich nach der geometrischen Anordnung des Endbereiches des Koaxialkabels (insbesondere zwecks reproduzierbarer Festlegung) bzw. nach der elektrischen Funktion (beispielsweise Verlöten des Innenleiters mit dem Kontaktpunkt auf der Leiterplatte) bzw. der hochfrequenztechnischen Zielsetzung (Anbindung der Abschirmung des Koaxialkabels an dem Kontaktpunkt auf der Leiterplatte zwecks Durchschleifen einer durchgehenden Abschirmung).

Ein Ausführungsbeispiel, das nach dem erfindungsgemäßen Verfahren hergestellt ist, wird im Folgenden erläutert und anhand der Figuren beschrieben.

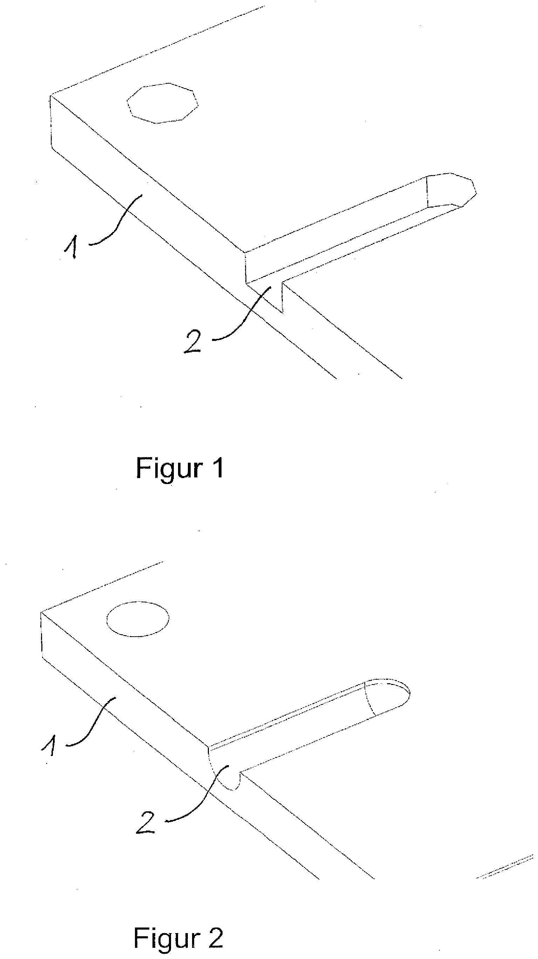

Figur 1 zeigt ausschnittsweise eine Leiterplatte 1 eines nicht näher dargestellten elektronischen Gerätes. Auf der Leiterplatte 1 sind in üblicher Weise elektrische und elektronische Bauteile zur Realisierung der Funktion des elektronischen Gerätes angeordnet. Die Leiterplatte 1 wird in ein nicht dargestelltes Gehäuse des elektronischen Gerätes eingesetzt. Nach der Erfindung ist ausgehend von einem Seitenbereich der Leiterplatte 1 eine Ausnehmung 2 in diese Leiterplatte eingebracht. Die Tiefe der Ausnehmung 2 entspricht in etwa der Hälfte der Dicke der Leiterplatte 1. Die Ausnehmung 2 wird mittels einer Stumpffräse eingefräst und hat eine vorgebbare Länge, eine vorgebbare Tiefe sowie eine vorgebbare Breite. Der Querschnitt ist in diesem Fall in etwa rechteckförmig.

Figur 2 zeigt eine alternative Gestaltung der Ausnehmung 2, die mittels einer Kugelfräse in die Leiterplatte 1 eingefräst wird. Auch hier hat die Ausnehmung 2 eine vorgebbare Breite und eine vorgebbare Länge sowie Tiefe, wobei sich aufgrund der Verwendung einer Kugelfräse ein halbrunder Querschnitt der Ausnehmung 2 einstellt.

Während in den Figuren 1 und 2 dargestellt ist, dass die jeweilige Ausnehmung 2 sich ausgehend von dem Randbereich der Leiterplatte 1 in Richtung des Innenbereiches erstreckt, kann die Ausnehmung 2 auch innerhalb des Innenbereiches der Leiterplatte 1 und damit beabstandet zu dem Randbereich der Leiterplatte 1 in die Oberfläche der Leiterplatte 1 eingefräst werden.

Die Figur 3 zeigt in einer Draufsicht von oben auf die Leiterplatte 1 die Anordnung eines entsprechend vorbereiteten Koaxialkabels 3 in der Ausnehmung 2.

Figur 4 zeigt die gleiche Anordnung wie in Figur 3, jedoch in einer perspektivischen Ansicht auf die Leiterplatte 1 von der Seite.

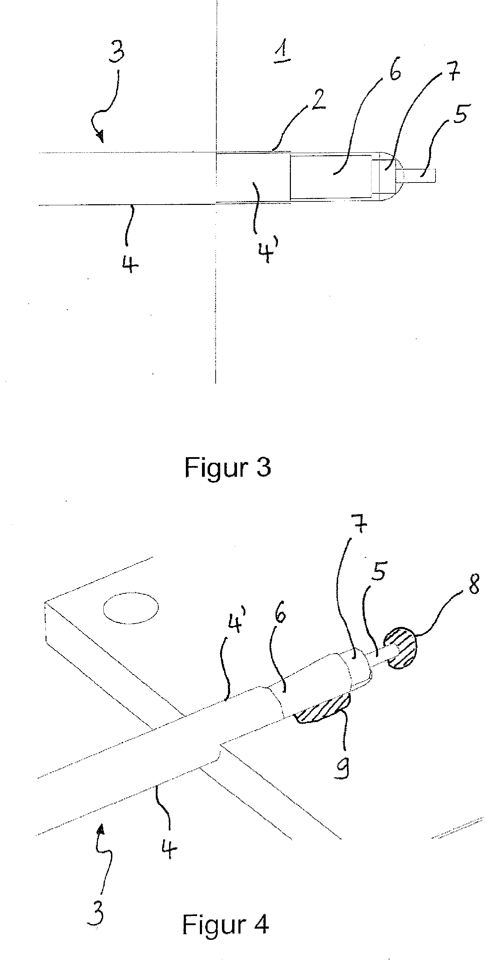

Dem Ausführungsbeispiel gemäß Figur 3 und 4 ist gemeinsam, dass das Koaxialkabel 3 in an sich bekannter Weise einen Außenmantel 4 aufweist und in dem Inneren koaxial ein Innenleiter 5 (zum Beispiel elektrisch leitfähiger Draht) angeordnet ist. Unter dem Außenmantel 4 befindet sich eine Abschirmung 6, zum Beispiel eine Folie oder ein Geflecht, zum Beispiel aus einem Aluminiumwerkstoff. Damit die elektrisch leitfähige Abschirmung 6 nicht in Kontakt kommt mit dem Innenleiter 5, ist zwischen dem Innenleiter 5 und der Abschirmung 6 ein Dielektrikum 7, beispielsweise aus einem Kunststoffwerkstoff, angeordnet. Ein solcher Aufbau eines Koaxialkabels 3 ist grundsätzlich bekannt.

Der entsprechend vorbereitete Endbereich des Koaxialkabels 3 wird in die Ausnehmung 2, die vorher in die Leiterplatte 1 eingebracht wurde, eingesetzt. Zu diesem Zweck wird der Innenleiter 5 freigelegt, wozu der Außenmantel 4, die Abschirmung 6 und das Dielektrikum 7 auf vorgebbarer Länge entfernt werden.

Anschließend wird das Dielektrikum 7 dadurch freigelegt, dass die es umgebende Abschirmung 6 und der Außenmantel 4 entfernt werden. Außerdem wird die Abschirmung 6 auf vorgebbarer Länge dadurch freigelegt, dass der Außenmantel 4 entfernt wird. Der derart vorbereitete Endbereich des Koaxialkabels wird dann derart in die Ausnehmung 2 eingesetzt, dass ein Endbereich des Außenmantels 4, in den

Figuren 3 und 4 als 4' bezeichnet, in die Ausnehmung eingesetzt, insbesondere eingepresst wird. Aufgrund der geringeren Außendurchmesser des Innenleiters 5, der Abschirmung 6 und des Dielektrikums 7 als die Breite bzw. Tiefe der Ausnehmung 2, haben diese Bereiche des Koaxialkabels 3 Abstand zu der Ausnehmung 2.

In Figur 4 ist dargestellt, dass auch der Leiterplatte 1 zumindest ein Kontaktpunkt 8 (auch als Lötpad bezeichnet), vorzugsweise genau ein Kontaktpunkt, sowie zumindest ein Kontaktpunkt 2, vorzugsweise ein Kontaktpunkt 9 auf der einen Seite der Ausnehmung 2 oder zwei Kontaktpunkte auf beiden Seiten der Ausnehmung 2, auf der Oberfläche der Leiterplatte 1 vorhanden sind. Über diese Kontaktpunkte 8, 9 werden der Innenleiter 5 und / oder die Abschirmung 6 des Koaxialkabels 3 elektrisch kontaktiert, zum Beispiel durch einen Lötvorgang.

Insbesondere in Figur 4 ist erkennbar, dass der Endbereich des Außenmantels 4, bezeichnet als 4' mit seiner Längsachse in etwa in der Längsachse der Ausnehmung 2 angeordnet ist, wobei die Längsachsen des Innenleiters 5, der Abschirmung 6 sowie des Dielektrikums 7 diese Längsachse der Ausnehmung 2 verlassen haben. Das bedeutet, dass der Endbereich des Koaxialkabels leicht nach oben gebogen ist, um zu gewährleisten, dass der Innenleiter 5 auf den Kontaktpunkt 8 aufliegen kann.

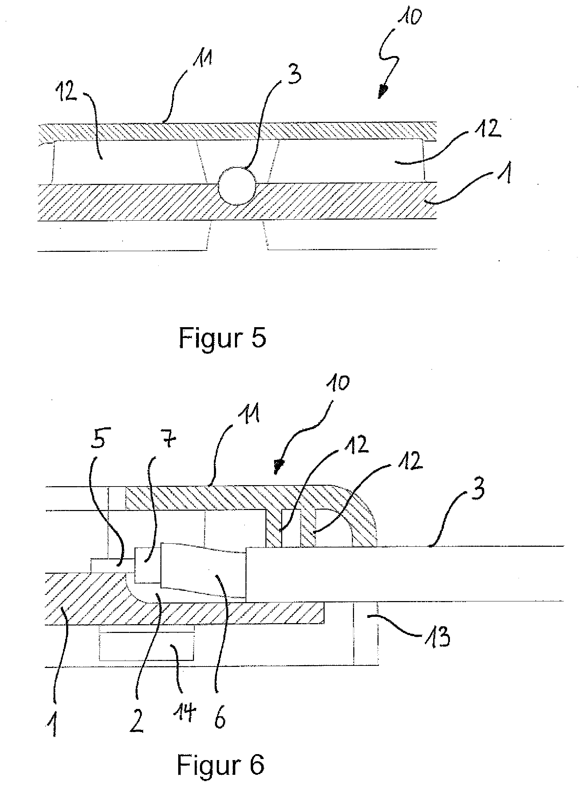

In den Figuren 5 und 6, die nicht erfindugsgemäß sind und lediglich der Veranschaulichung dienen, 6- ist eine Abdeckung 10 dargestellt, die den Endbereich des Koaxialkabels 3 innerhalb der Ausnehmung 2 abdeckt. Die Abdeckung 10 ist in einer Variante nur auf der einen Oberseite der Leiterplatte 1 angeordnet. Es ist aber auch denkbar, dass die Abdeckung 10 symmetrisch oder abweichend von einer symmetrischen Ausgestaltung auf beiden Oberseiten der Leiterplatte 1 angeordnet wird.

Bei dem Ausführungsbeispiel gemäß Figuren 5 und 6, das nicht erfindungsgemäß ist, ist die Abdeckung 10 auf beiden Oberseiten der Leiterplatte 1 asymmetrisch angeordnet.

Die Abdeckung 10 besteht aus einer Oberseite 11, die einen Steg 12 (oder auch mehrere Stege 12, wie in Figur 6 erkennbar) aufweist, der in Richtung der Oberseite der Leiterplatte 1 weist. Es kann, aber es muss nicht ein Frontsteg 13 vorhanden sein, der parallel zu der Seitenkante der Leiterplatte 1, von der die Ausnehmung 2 ausgeht, ausgerichtet ist (Figur 6). Die Oberseite 11 der Abdeckung 10 deckt zumindest die in die Ausnehmung 2 eingesetzten Teile des Koaxialkabels 3 ab, vorzugsweise erstreckt sie sich aber auch darüber hinaus.

Zur Festlegung der Abdeckung 10 weist diese in geeigneter Weise einen Rasthaken 14 (ggf. auch mehr als einen Rasthaken 14) auf, mit dem die Abdeckung 10 an der Leiterplatte 1 festgelegt wird.

Bei dem gezeigten Ausführungsbeispiel der Abdeckung 10 weist der Frontsteg 13 eine Öffnung für das Koaxialkabel auf, sodass es nicht nur denkbar ist, die Abdeckung 10 mit ihrem zumindest einen Rasthaken 14 rastend an der Leiterplatte 1 festzulegen, sondern alternativ dazu die Abdeckung 10 auf die Leiterplatte 1 aufzuschieben, wozu der Rasthaken 14 dann als Führungselement ausgebildet ist. Vor allen Dingen mit dem zumindest einen Steg 12, der auf den Endbereich des Außenmantels 4 einwirkt (insbesondere drückt), wird eine mechanische Festlegung und damit in vorteilhafter Weise eine Zugentlastung realisiert.

Während die in den Figuren 5 und 6 dargestellte Abdeckung 10 als ein separates Bauteil hergestellt und anschließend montiert wird, ist es denkbar, den Bereich der Ausnehmung 2 mit dem dort angeordneten und kontaktierten Koaxialkabel 3 zum Beispiel mit einer Vergussmasse zu schützen und ggf. dadurch auch eine Zugentlastung zu erzielen.

Es folgt eine Kurzdarstellung der Erfindung mit anderen Worten:

### 1 Problem

Die Direktmontage von Koaxialkabeln auf Leiterplattenmaterial ist per Handlötvorgang ungenau und im Hochfrequenzbereich undefiniert. Eine zusätzliche platzsparende Zugentlastung ist durch eine durchgehende Fräsung im Leiterplattenmaterial nicht möglich.

### 2 Lösungs-Prinzip

Mittels einer teilweisen Einfräsung einer geeigneten dicken Leiterplatte auf etwa die Hälfte des Kabeldurchmessers lässt sich das Kabelende definiert auf der Leiterplatte anordnen und der elektrische Leiter des Kabels definiert mit einem Kontaktpunkt, insbesondere einem Ende einer Leiterbahn, auf der Leiterplatte verlöten. Zusätzlich erlaubt die Teileinfräsung der Leiterplatte weiterhin ein mechanisches Gegenpressen eines Anbauteils auf den Kabelmantel zur Zugentlastung.

### 3 Umsetzung

Die Leiterplatte wird auf der Länge des abisolierten Dielektrikums des Koaxialkabels eingefräst. Die Breite der Fräsung entspricht dem Durchmesser der Koaxialleitung. Die Tiefe der Fräsung entspricht etwa dem Außenradius der Koaxialleitung, wobei hier sicher zu stellen ist, dass die tiefe der Einfräsung ausreichend ist, um das Koaxialkabel in der Breite stramm in der Leiterplatte zu halten.

Am Fräsrand werden seitlich auf der Höhe des abisolierten Kabelschirms Lötpads angebracht, um die Masseanbindung des Koaxialkabels sicher zu stellen. Der überstehende Innenleiter wird auf einem weiteren Lötpad angelötet. Vorzugsweise wird zusätzlich ein Deckel verwendet, der zumindest eine Rippe aufweist, die im montierten Zustand die Koaxialleitung von oben umfasst und in der Einfräsung zusätzlich fixiert.

### 4 Ablauf

1.) Die Einfräsung wird im Leiterplattendesign berücksichtigt
2.) Bei der Kabelmontage wird das Koaxialkabel in die Fräsung eingelegt
3.) Das Kabel wird bündig so eingelegt, dass das Dielektrikum am Ende der Fräsung anliegt
4.) Das Kabel wird mittels einer Haltevorrichtung in der Fräsung gehalten
5.) Das Kabel wird angelötet
6.) Durch eine Haltevorrichtung an einem Anbauteil wird die Zugentlastung sichergestellt.

### 5 Verwendung

Montage von Antennen, die:
- durch die hohen Frequenzen präzise Prozesse benötigen
- automatisch gelötet werden
- Zugentlastung am Kabel sicherstellen müssen

Mittels einer teilweisen Einfräsung einer geeigneten dicken Leiterplatte auf etwa die Hälfte des Kabeldurchmessers lässt sich das Kabelende definiert auf der Leiterplatte anordnen und der elektrische Leiter des Kabels definiert mit einem Kontaktpunkt, insbesondere einem Ende einer Leiterbahn, auf der Leiterplatte verlöten.

## Patentansprüche

1. Verfahren zum Verbinden einer Leiterplatte (1) mit einem Koaxialkabel (3), wobei das Koaxialkabel (3) einen Innenleiter (5) aufweist, der von einem Dielektrikum (7) umgeben ist, das wiederum von einer Abschirmung (6) umgeben ist, wobei das Dielektrikum (7) von einem Außenmantel (4) umgeben ist, wobei der Innenleiter (5) mit einem Kontaktpunkt (8) auf der Leiterplatte (1) zwecks elektrischer Kontaktierung verlötet wird, wobei die Leiterplatte (1) mit einer von ihrer Oberfläche ausgehenden Ausnehmung (2) versehen und der Endbereich des Außenmantels (4) des Koaxialkabels (3) zumindest teilweise in die Ausnehmung (2) eingesetzt wird, wobei zumindest teilweise neben der Ausnehmung (2) ein weiterer Kontaktpunkt (9) vorhanden ist, mit dem die Abschirmung (6) des Koaxialkabels (3) elektrisch verbunden, insbesondere verlötet wird, **dadurch gekennzeichnet, dass** die Ausnehmung (2) und ein Teilbereich darum herum mit einer Abdeckung (11) versehen werden, wobei die Abdeckung (11) aus einem flüssigen oder zähflüssigen Material hergestellt wird und der Bereich des Endes des Koaxialkabels (3) sowie die Kontaktpunkte (8, 9) damit überzogen werden.

2. Verfahren nach Anspruch 1, **dadurch gekennzeichnet, dass** die Breite der Ausnehmung (2) geringfügig kleiner gewählt wird als der Außendurchmesser des Außenmantels (4) des Koaxialkabels (3) und dieser zumindest teilweise in die Ausnehmung (2) eingepresst wird.

3. Verfahren nach Anspruch 1 oder 2, **dadurch gekennzeichnet, dass** die Ausnehmung (2) von einer Seite der Leiterplatte (1) ausgehend in diese eingebracht wird.

4. Verfahren nach Anspruch 1, 2 oder 3, **dadurch gekennzeichnet, dass** die Ausnehmung (2) mittels eines Fräsvorganges in die Leiterplatte (1) eingebracht wird.

5. Verfahren nach einem der vorhergehenden Ansprüche, **dadurch gekennzeichnet, dass** die Tiefe der Ausnehmung (2) in der Leiterplatte (1) größer als mindestens die Hälfte des Außendurchmessers des Außenmantels (4) des Koaxialkabels (3) gewählt wird.

6. Verfahren nach einem der vorhergehenden Ansprüche, **dadurch gekennzeichnet, dass** die Tiefe der Ausnehmung (2) in der Leiterplatte (1) kleiner oder gleich der Dicke der Leiterplatte (1) gewählt wird.

7. Verfahren nach einem der vorhergehenden Ansprüche, **dadurch gekennzeichnet, dass** die Ausnehmung (2) in der Leiterplatte (1) in einer Länge eingebracht wird, die der Summe der Länge des freigelegten Innenleiters (5), der Länge des freigelegten Dielektrikums (7), der Länge der freigelegten Abschirmung (6) und der vorgebbaren Länge des Außenmantels (4) des Koaxialkabels (3) entspricht.

## Claims

1. Method for connecting a printed circuit board (1) to a coaxial cable (3), wherein the coaxial cable (3) has an internal conductor (5) which is surrounded by a dielectric (7) which, in turn, is surrounded by a shield (6), wherein the dielectric (7) is surrounded by an outer sheath (4), wherein the internal conductor (5) is soldered to a contact point (8) on the printed circuit board (1) for the purpose of electrical contacting, wherein the printed circuit board (1) is equipped with a recess (2) which starts from the surface of the printed circuit board and the end region of the outer sheath (4) of the coaxial cable (3) is inserted at least partially into the recess (2), wherein a further contact point (9) is present at least partially adjacent to the recess (2), to which contact point the shield (6) of the coaxial cable (3) is electrically connected, in particular soldered, **characterized in that** the recess (2) and a partial region around it are equipped with a cover (11), wherein the cover (11) is produced from a liquid or viscous material and the region of the end of the coaxial cable (3) and the contact points (8, 9) are covered therewith.

2. Method according to Claim 1, **characterized in that** the width of the recess (2) is selected to be slightly smaller than the external diameter of the outer sheath (4) of the coaxial cable (3) and this is pressed at least partially into the recess (2).

3. Method according to Claim 1 or 2, **characterized in that** the recess (2) is incorporated into the printed circuit board (1) starting from a side of the printed circuit board.

4. Method according to Claim 1, 2 or 3, **characterized in that** the recess (2) is incorporated into the printed circuit board (1) by means of a milling procedure.

5. Method according to one of the preceding claims, **characterized in that** the depth of the recess (2) in the printed circuit board (1) is selected to be greater than at least half the external diameter of the outer sheath (4) of the coaxial cable (3).

6. Method according to one of the preceding claims, **characterized in that** the depth of the recess (2) in the printed circuit board (1) is selected to be smaller than or equal to the thickness of the printed circuit board (1) .

7. Method according to one of the preceding claims, **characterized in that** the recess (2) in the printed circuit board (1) is incorporated in a length which corresponds to the sum of the length of the exposed internal conductor (5), the length of the exposed dielectric (7), the length of the exposed shield (6) and the predeterminable length of the outer sheath (4) of the coaxial cable (3).

## Revendications

1. Procédé de connexion d'une plaquette de circuits imprimés (1) à un câble coaxial (3), le câble coaxial (3) comprenant un conducteur intérieur (5), qui est entouré d'un diélectrique (7), qui est lui-même entouré d'un blindage (6), le diélectrique (7) étant entouré d'une gaine extérieure (4), le conducteur intérieur (5) étant brasé à un point de contact (8) sur la plaquette de circuits imprimés (1) en vue d'une mise en contact électrique, la plaquette de circuits imprimés (1) étant pourvue d'un évidement (2) partant de sa surface et la zone d'extrémité de la gaine extérieure (4) du câble coaxial (3) étant insérée au moins partiellement dans l'évidement (2), un autre point de contact (9) étant présent au moins partiellement à côté de l'évidement (2), auquel le blindage (6) du câble coaxial (3) est connecté électriquement, en particulier brasé, **caractérisé en ce que** l'évidement (2) et une zone partielle autour de celui-ci sont pourvus d'un recouvrement (11), le recouvrement (11) étant fabriqué à partir d'un matériau liquide ou visqueux et la zone de l'extrémité du câble coaxial (3) ainsi que les points de contact (8, 9) étant revêtus de celui-ci.

2. Procédé selon la revendication 1, **caractérisé en ce que** la largeur de l'évidement (2) est choisie légèrement inférieure au diamètre extérieur de la gaine extérieure (4) du câble coaxial (3) et celle-ci est au moins partiellement enfoncée dans l'évidement (2).

3. Procédé selon la revendication 1 ou 2, **caractérisé en ce que** l'évidement (2) est réalisé dans la plaquette de circuits imprimés (1) en partant d'un côté de celle-ci.

4. Procédé selon la revendication 1, 2 ou 3, **caractérisé en ce que** l'évidement (2) est réalisé dans la plaquette de circuits imprimés (1) au moyen d'une opération de fraisage.

5. Procédé selon l'une quelconque des revendications précédentes, **caractérisé en ce que** la profondeur de l'évidement (2) dans la plaquette de circuits imprimés (1) est choisie supérieure à au moins la moitié du diamètre extérieur de la gaine extérieure (4) du câble coaxial (3).

6. Procédé selon l'une quelconque des revendications précédentes, **caractérisé en ce que** la profondeur de l'évidement (2) dans la plaquette de circuits imprimés (1) est choisie inférieure ou égale à l'épaisseur de la plaquette de circuits imprimés (1).

7. Procédé selon l'une quelconque des revendications précédentes, **caractérisé en ce que** l'évidement (2) dans la plaquette de circuits imprimés (1) est réalisé sur une longueur qui correspond à la somme de la longueur du conducteur intérieur (5) exposé, de la longueur du diélectrique (7) exposé, de la longueur du blindage (6) exposé et de la longueur prédéterminable de la gaine extérieure (4) du câble coaxial (3).
